# EUROPEAN PATENT APPLICATION

(11) **EP 4 835 416 A1**
(43) Date of publication of application: **04.11.2026**
(21) Application number: 25865795.6
(22) Date of filing: 08.07.2025
(51) Int. Cl.: G01J 1/02

(54) **INFRARED DETECTION ELEMENT, INFRARED SENSOR, AND METHOD FOR MANUFACTURING INFRARED DETECTION ELEMENT**

(30) Priority: 10.09.2024 JP 2024156937
(71) Applicant: Panasonic Intellectual Property Management Co., Ltd., Kadoma-shi, Osaka 571-0057 (JP)
(72) Inventor: HARAGUCHI, Yasushi, Kadoma-shi, Osaka 571-0057 (JP); KURODA, Tsuyoshi, Kadoma-shi, Osaka 571-0057 (JP); HIGASISUJI, Tosiyuki, Kadoma-shi, Osaka 571-0057 (JP); ADACHI, Hiroshi, Kadoma-shi, Osaka 571-0057 (JP)
(74) Representative: Müller-Boré & Partner Patentanwälte PartG mbB
(86) International application number: PCT/JP2025/024524
(87) International publication number: WO 2026/058560

(57) **Abstract**

The problem to be overcome by the present disclosure is to contribute to increasing the sensitivity of an infrared detection element. An infrared detection element (10) includes a pyroelectric substrate (1), a first electrode (2), a second electrode (3), and an infrared absorbing layer (4). The pyroelectric substrate (1) has a first surface (11) and a second surface (12) in a thickness direction (D1). The first electrode (2) is provided on the first surface (11) of the pyroelectric substrate (1). The second electrode (3) is provided on the second surface (12) of the pyroelectric substrate (1) such that the second electrode (3) overlaps with the first electrode (2) in the thickness direction (D1). The infrared absorbing layer (4) is provided on the first electrode (2). The pyroelectric substrate (1) has a through hole (19) penetrating through the pyroelectric substrate (1) in the thickness direction (D1). The through hole (19) is provided around a specific portion (13), sandwiched between the first electrode (2) and the second electrode 3, of the pyroelectric substrate (1). The through hole (19) has a tapered structure in which a width of the through hole (19) as measured adjacent to the first surface (11) is narrower than a width of the through hole (19) as measured adjacent to the second surface (12).

## Description

### Technical Field

The present disclosure generally relates to an infrared detection element, an infrared sensor, and a method for manufacturing the infrared detection element. More particularly, the present disclosure relates to an infrared detection element which uses a pyroelectric substrate, an infrared sensor, and a method for manufacturing the infrared detection element.

### Background Art

Patent Literature 1 discloses a pyroelectric infrared detection element. In the infrared detection element, a photodetector unit is provided by respectively forming a pair of upper and lower electrodes on the front and reverse surfaces of a pyroelectric substrate. An infrared ray is incident on the photodetector unit to generate electric charges. In addition, the photodetector unit is supported by a cantilever forming a part of the pyroelectric substrate which is formed by cutting out a hole surrounding the photodetector unit on three sides thereof.

In the field of infrared detection elements using a pyroelectric substrate, the sensitivity thereof sometimes needs to be increased.

### Citation List

### Patent Literature

Patent Literature 1: JP H10-2793 A

### Summary of Invention

An object of the present disclosure is to contribute to increasing the sensitivity of an infrared detection element.

An infrared detection element according to an aspect of the present disclosure includes a pyroelectric substrate, a first electrode, a second electrode, and an infrared absorbing layer. The pyroelectric substrate has a first surface and a second surface in a thickness direction. The first electrode is provided on the first surface of the pyroelectric substrate. The second electrode is provided on the second surface of the pyroelectric substrate such that the second electrode overlaps with the first electrode in the thickness direction. The infrared absorbing layer is provided on the first electrode. The pyroelectric substrate has a through hole penetrating through the pyroelectric substrate in the thickness direction. The through hole is provided around a specific portion, sandwiched between the first electrode and the second electrode, of the pyroelectric substrate. The through hole has a tapered structure in which a width of the through hole as measured adjacent to the first surface is narrower than a width of the through hole as measured adjacent to the second surface.

An infrared sensor according to another aspect of the present disclosure includes the infrared detection element described above, a mounting board, and a package. The infrared detection element is mounted on the mounting board. The package houses the infrared detection element and the mounting board.

A method for manufacturing an infrared detection element according to still another aspect of the present disclosure includes a first electrode forming process step, a second electrode forming process step, an infrared absorbing layer forming process step, and a through hole forming process step. The first electrode forming process step includes forming a first electrode on a first surface of a pyroelectric substrate. The pyroelectric substrate has the first surface and a second surface in a thickness direction. The second electrode forming process step includes forming a second electrode on the second surface of the pyroelectric substrate such that the second electrode overlaps with the first electrode in the thickness direction. The infrared absorbing layer forming process step includes forming an infrared absorbing layer on the first electrode. The through hole forming process step is performed after the infrared absorbing layer forming process step has been performed. The through hole forming process step includes forming a through hole through the pyroelectric substrate such that the through hole surrounds a specific portion sandwiched between the first electrode and the second electrode. The through hole has a tapered structure in which a width of the through hole as measured adjacent to the first surface is narrower than a width of the through hole as measured adjacent to the second surface.

### Brief Description of Drawings

[FIG. 1] FIG. 1 is a top view of an infrared detection element according to an embodiment of the present disclosure;
[FIG. 2] FIG. 2 is a bottom view of the infrared detection element;
[FIG. 3] FIG. 3 is a cross-sectional view thereof taken along the plane indicated by the arrows III-III shown in FIG. 1;
[FIG. 4] FIG. 4 is a cross-sectional view thereof taken along the plane indicated by the arrows IV-IV shown in FIG. 1;
[FIG. 5] FIG. 5 is an exploded perspective view of an infrared sensor including the infrared detection element;
[FIG. 6] FIG. 6 is a flowchart showing a method for manufacturing the infrared detection element;
[FIG. 7] FIG. 7 illustrates how a through hole forming process step of the method for manufacturing the infrared detection element is performed;
[FIG. 8] FIG. 8 is a cross-sectional view of an infrared detection element according to a first variation;
[FIG. 9] FIG. 9 illustrates one process step of a method for manufacturing an infrared detection element according to a second variation; and
[FIG. 10] FIG. 10 illustrates one process step of a method for manufacturing an infrared detection element according to a comparative example.

### Description of Embodiments

An infrared detection element and infrared sensor according to an exemplary embodiment of the present disclosure will now be described with reference to the accompanying drawings. Note that the drawings to be referred to in the following description of embodiments are all schematic representations. Thus, the ratio of the dimensions (including thicknesses) of respective constituent elements illustrated in the drawings does not always reflect their actual dimensional ratio.

### (1) Embodiment

### (1.1) Overview

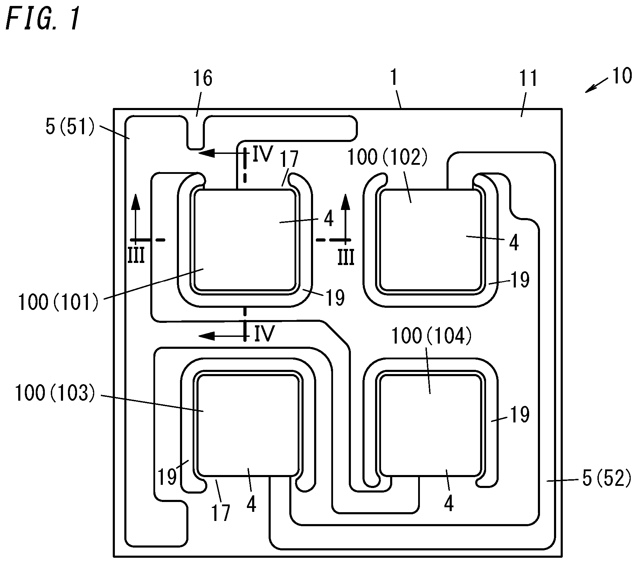

As shown in FIGS. 1-4, an infrared detection element 10 according to this embodiment includes a pyroelectric substrate 1, a first electrode 2, a second electrode 3, and an infrared absorbing layer 4.

The pyroelectric substrate 1 has a first surface 11 and a second surface 12 in a thickness direction D1.

The first electrode 2 is provided on the first surface 11 of the pyroelectric substrate 1. The second electrode 3 is provided on the second surface 12 of the pyroelectric substrate 1 such that the second electrode 3 overlaps with the first electrode 2 in the thickness direction D1. The infrared absorbing layer 4 is provided on the first electrode 2.

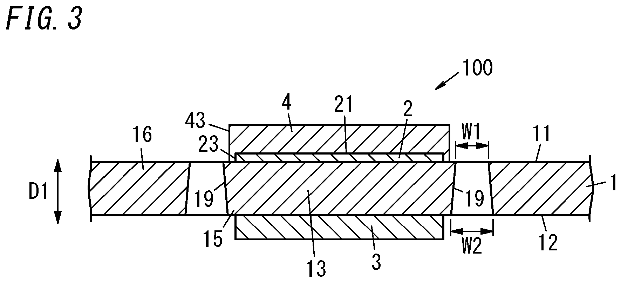

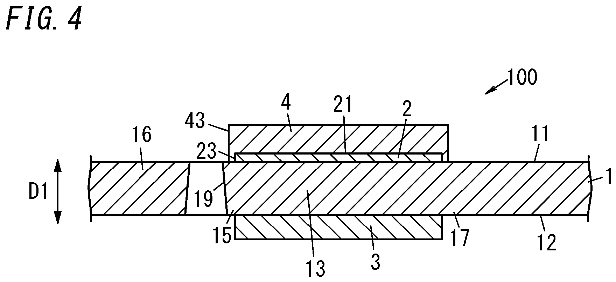

The pyroelectric substrate 1 has a through hole 19 penetrating through the pyroelectric substrate 1 in the thickness direction D1. The through hole 19 is provided to surround a specific portion 13 sandwiched between the first electrode 2 and second electrode 3 of the pyroelectric substrate 1. As shown in FIGS. 3 and 4, the through hole 19 has a tapered structure in which a width of the through hole 19 as measured adjacent to the first surface 11 is narrower than a width of the through hole 19 as measured adjacent to the second surface 12.

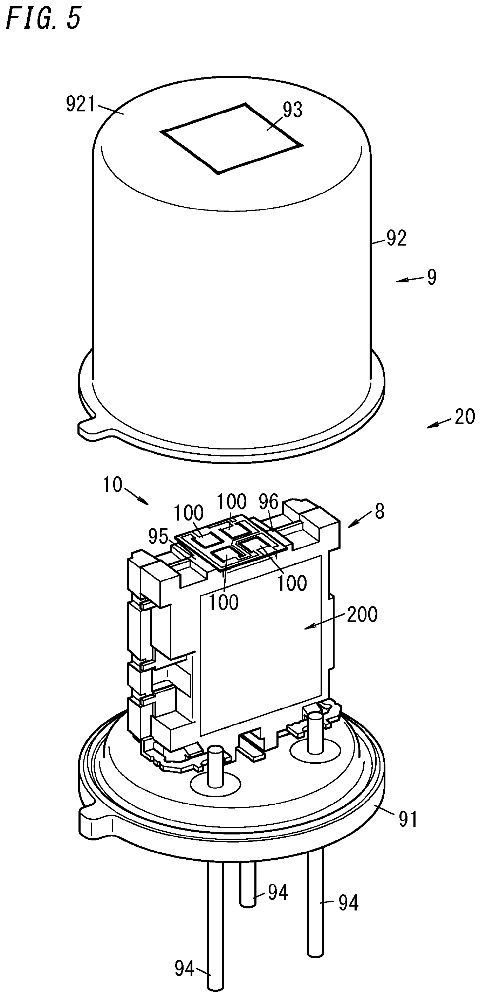

As shown in FIG. 5, an infrared sensor 20 includes the infrared detection element 10, a mounting board 8 on which the infrared detection element 10 is mounted, and a package 9 for housing the infrared detection element 10 and the mounting board 8.

The infrared detection element 10 and infrared sensor 20 according to this embodiment increase the absorption rate of infrared rays because the infrared detection element 10 includes the infrared absorbing layer 4. This may contribute to increasing the sensitivity of the infrared detection element 10. In addition, as will be described in detail later, the through hole 19 has a tapered structure in which its width adjacent to the first surface 11 is narrower than its width adjacent to the second surface 12, which also allows for contributing to increasing the sensitivity of the infrared detection element 10.

### (1.2) Details

Respective constituent elements of the infrared detection element 10 and infrared sensor 20 will now be described in more detail.

In the following description, for the sake of convenience, a direction aligned with the thickness direction D1 defined with respect to the pyroelectric substrate 1 of the infrared detection element 10 will hereinafter sometimes be referred to as an "upward/downward direction." A direction pointing from the second surface 12 toward the first surface 11 will hereinafter sometimes be referred to as an "upward direction" and the opposite direction pointing from the first surface 11 toward the second surface 12 will hereinafter sometimes be referred to as a "downward direction." In addition, in the following description, the phrase "when viewed in plan" means viewing any member in the thickness direction D1 defined with respect to the pyroelectric substrate 1 (i.e., viewing the member from above or from below the member). However, these definitions of directions according to this disclosure only indicate the relative positions of members of the infrared detection element 10 and infrared sensor 20 and should not be construed as defining the direction in which the infrared detection element 10 and the infrared sensor 20 are supposed to be used, for example.

### (1.2.1) Infrared Detection Element

As shown in FIGS. 1-4, the infrared detection element 10 includes the pyroelectric substrate 1, four first electrodes 2, four second electrodes 3, and four infrared absorbing layers 4.

The pyroelectric substrate 1 has the shape of a rectangular plate. The pyroelectric substrate 1 has a square shape, for example, when viewed in plan. However, the shape of the pyroelectric substrate 1 is not limited to any particular one. The pyroelectric substrate 1 is a substrate having pyroelectricity. The pyroelectric substrate 1 is configured as, for example, a single-crystal LiTaO₃ substrate. The direction of spontaneous polarization of the pyroelectric substrate 1 is one direction aligned with the thickness direction D1 defined with respect to the pyroelectric substrate 1 and is, for example, the upward direction.

The pyroelectric substrate 1 has a thickness of, for example, 50 µm. However, this should not be construed as limiting. Rather, the thickness of the pyroelectric substrate 1 is preferably set to fall within the range of approximately 30 µm to approximately 150 µm from the viewpoint of ensuring sufficient detection sensitivity to an infrared ray and sufficient mechanical strength for the pyroelectric substrate 1.

Each of the first electrodes 2 (hereinafter simply referred to as "the first electrode 2") is an electrically conductive layer made of a material which has electrical conductivity and absorbs infrared rays. A material for the first electrode 2 is nickel (Ni). However, this should not be construed as limiting. Alternatively, the material of the first electrode 2 may also be, for example, nickel chromium (NiCr) or black gold.

The four first electrodes 2 are provided on the first surface 11 (upper surface) of the pyroelectric substrate 1. The four first electrodes 2 are respectively provided in four different areas of the first surface 11. The four first electrodes 2 are arranged to form a 2 × 2 matrix. The four first electrodes 2 are spaced apart from each other.

Each of the first electrodes 2 has, for example, a rectangular shape, and may have a square shape, when viewed in plan. The first electrode 2 has a thickness equal to or greater than 0.05 µm and equal to or less than 5 µm, for example. The four first electrodes 2 have the same shape, the same dimensions, and the same thickness, and are made of the same material.

The second electrodes 3 are made of a material which has electrical conductivity. The second electrodes 3 are made of the same material as the first electrodes 2. However, this should not be construed as limiting. Alternatively, the second electrodes 3 may also be made of a material different from the material of the first electrodes 2.

The four second electrodes 3 are provided on the second surface 12 (lower surface) of the pyroelectric substrate 1. The four second electrodes 3 correspond one to one to the four first electrodes 2. As shown in FIGS. 3 and 4, each of the second electrodes 3 (hereinafter simply referred to as "the second electrode 3") is provided on the second surface 12 of the pyroelectric substrate 1 such that the second electrode 3 overlaps with a corresponding one of the first electrodes 2 in the thickness direction D1. The four second electrodes 3 are spaced apart from each other. As used herein, the expression "the second electrode 3 overlaps with the first electrode 2 in the thickness direction D1" means that at least a part (i.e., part or all) of the second electrode 3 overlaps with the first electrode 2 when the infrared detection element 10 is viewed in the thickness direction D1.

Each of the second electrodes 3 has, for example, a rectangular shape, and may have a square shape, when viewed in plan. The second electrode 3 has a thickness equal to or greater than 0.05 µm and equal to or less than 5 µm, for example. The thickness of each of the second electrodes 3 may be the same as, or different from, the corresponding one of the first electrodes 2, whichever is appropriate. The four second electrodes 3 have the same shape, the same dimensions, and the same thickness, and are made of the same material.

Each of the second electrodes 3 is formed to have the same shape and the same dimensions as the corresponding one of the first electrodes 2. In this embodiment, the outer peripheral edges of each of the second electrodes 3 conform to the outer peripheral edges of the corresponding one of the first electrodes 2 when viewed in plan. That is to say, in this embodiment, the second electrode 3 overlaps in its entirety with the first electrode 2 when viewed in the thickness direction D1.

The infrared absorbing layers 4 are layers made of resin into which an electrically conductive fine powder is dispersed. The infrared absorbing layers 4 each have a thickness equal to or greater than 0.1 µm and equal to or less than 5 µm, for example.

The four infrared absorbing layers 4 correspond one to one to the four first electrodes 2. Each of the infrared absorbing layers 4 is provided on the corresponding one of the first electrodes 2. In this embodiment, each of the infrared absorbing layers 4 covers the upper surface 21 of the corresponding one of the first electrodes 2. In addition, each of the infrared absorbing layers 4 covers side surfaces 23 of the corresponding one of the first electrodes 2. In this embodiment, as shown in FIGS. 1, 3, and 4, each of the infrared absorbing layers 4 covers the corresponding one of the first electrodes 2 entirely (i.e., every surface of the first electrode 2 but its surface that is in contact with the pyroelectric substrate 1). Alternatively, each of the infrared absorbing layers 4 does not have to cover the upper surface of the corresponding one of the first electrodes 2 entirely but may cover the upper surface of the first electrode 2 only partially. That is to say, each of the infrared absorbing layers 4 (hereinafter simply referred to as "the infrared absorbing layer 4") only needs to be provided on at least a part of the upper surface of the corresponding one of the first electrodes 2. In addition, in this embodiment, the infrared absorbing layer 4 covers all of the four side surfaces 23 of the first electrode 2 having a rectangular shape. However, this should not be construed as limiting. Alternatively, the infrared absorbing layer 4 may also cover one or more side surfaces 23 out of the four side surfaces 23 of the first electrode 2. Furthermore, in this embodiment, the infrared absorbing layer 4 entirely covers each of the four side surfaces 23. However, this should not be construed as limiting. Alternatively, the infrared absorbing layer 4 may also cover only a part of each side surface 23.

The resin as a material for the infrared absorbing layer 4 is, for example, a thermosetting resin. Examples of the thermosetting resins include phenolic resins, epoxy resins, melamine resins, urea resins, unsaturated polyester resins, alkyd resins, polyurethane resins, and thermosetting polyimide resins. The infrared absorbing layer 4 is preferably made of any one of these thermosetting resins which has a higher absorptivity with respect to an infrared ray to be detected by the infrared detection element 10. When the infrared sensor 20 is used, for example, for detecting a gas and the wavelength of infrared rays to be detected falls within the range of 3 µm to 8 µm, the infrared absorbing layer 4 is preferably made of a resin containing a hydroxyl group. When the infrared sensor 20 is used, for example, for sensing a human body and the wavelength of an infrared ray to be detected falls within the range of 8 µm to 13 µm, the infrared absorbing layer 4 is preferably made of an aromatic resin.

In the infrared absorbing layer 4, examples of the electrically conductive fine powder dispersed into the resin include carbon-based fine powders, metallic fine powders, and metal oxide based fine powders. The volume concentration of the electrically conductive fine powder may be set to fall within the range of approximately 1% to approximately 30%, for example. Thus, the infrared absorbing layer 4 comes to have electrical conductivity but comes to have a higher resistivity than the first electrode 2.

The infrared detection element 10 includes four detection units 100. Each of the four detection units 100 includes: one of the first electrodes 2; the second electrode 3 corresponding to this first electrode 2; the infrared absorbing layer 4 provided on this first electrode 2; and a part (hereinafter referred to as a "specific portion 13"), sandwiched between this first electrode 2 and the second electrode 3, of the pyroelectric substrate 1. The specific portion 13 has, in this embodiment, a rectangular shape when viewed in plan. In the following description, if the four detection units 100 need to be distinguished from each other, the four detection units 100 will be hereinafter referred to as "detection units 101-104."

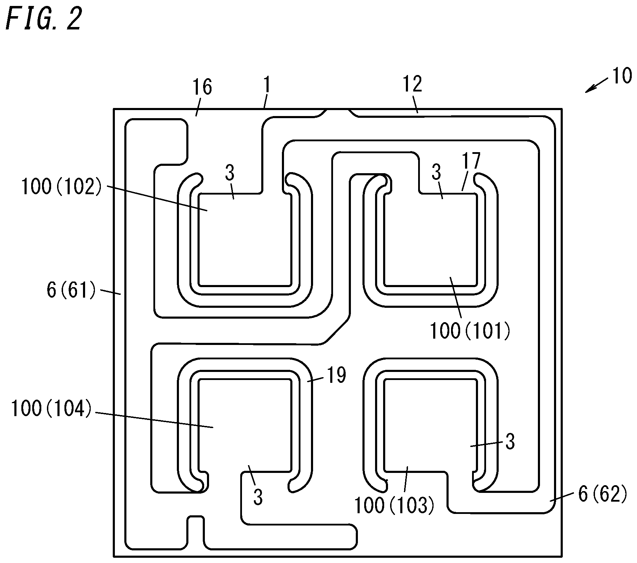

As shown in FIGS. 1 and 2, the four detection units 101-104 are arranged to form a 2 × 2 matrix such that the detection unit 101 is disposed at the front left, the detection unit 102 is disposed at the front right, the detection unit 103 is disposed at the back left, and the detection unit 104 is disposed at the back right. The four detection units 101-104 are arranged to have 180-degree rotational symmetry when viewed in plan. In addition, the four detection units 101-104 are arranged to have line symmetry in each of two directions intersecting at right angles with the upward/downward direction which are perpendicular to each other (i.e., a forward/backward direction and a rightward/leftward direction) when viewed in plan.

In the pyroelectric substrate 1, the four through holes 19 penetrating through the pyroelectric substrate 1 in the thickness direction D1 are provided around four specific portions 13, respectively. In the following description, for the sake of convenience, each of the four portions, surrounded by a corresponding one of the four through holes 19, of the pyroelectric substrate 1 will be hereinafter referred to as a "predetermined portion 15" and a portion, supporting the predetermined portion 15, of the pyroelectric substrate 1 will be hereinafter referred to as a "supporting portion 16" (refer to FIGS. 3 and 4). The predetermined portion 15 may correspond with, or be different from, its corresponding specific portion 13. In this embodiment, the predetermined portion 15 is different from the specific portion 13 and is larger by one step than the specific portion 13 when viewed in plan. As shown in FIGS. 1 and 4, the predetermined portion 15 is supported by the supporting portion 16 via the beam portion 17 configured as a cantilever. The predetermined portion 15 is thermally insulated, by the through hole 19, from the supporting portion 16 except the beam portion 17. Thus, in the infrared detection element 10, the four detection units 100 are thermally insulated from each other.

Each of the through holes 19 is formed, around its corresponding specific portion 13 (i.e., a part, sandwiched between the first electrode 2 and the second electrode 3, of the pyroelectric substrate 1), so as to extend along three sides of the specific portion 13. Forming such through holes 19, each extending along the three sides of the corresponding specific portion 13, improves the thermal insulation properties of the detection units 100, thus contributing to further increasing the sensitivity of the infrared detection element 10.

Each of the through holes 19 is formed to be spaced apart from its corresponding specific portion 13 when viewed in plan. That is to say, the inner surfaces of each of the through holes 19 of the pyroelectric substrate 1 are spaced apart from the first and second electrodes 2, 3 when viewed in plan. In addition, as shown in FIGS. 3 and 4, each of the through holes 19 is formed through the pyroelectric substrate 1 to be located outside the side surfaces 43 of the infrared absorbing layer 4 of the corresponding one of the detection units 100 when viewed in plan.

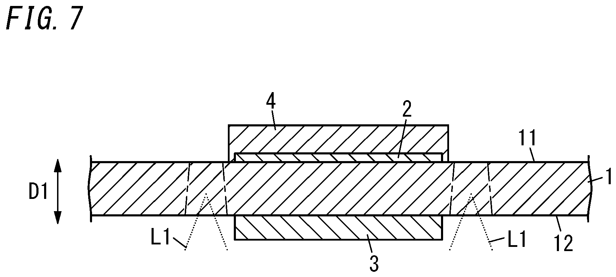

As shown in FIGS. 3 and 4, each of the through holes 19 has a tapered structure in which its width W1 adjacent to the first surface 11 is narrower than its width W2 adjacent to the second surface 12. The tapered structure of each of the through holes 19 includes a part of which the width gradually decreases from the second surface 12 toward the first surface 11. In a direction in which the through hole 19 extends (a direction perpendicular to the plane of FIG. 3), the shape of the through hole 19 (i.e., the shape of the through hole 19 in the cross section illustrated in FIG. 3) is substantially uniform. The through hole 19 having such a tapered structure may be formed, for example, by irradiating the pyroelectric substrate 1 with a laser beam L1 (refer to FIG. 7) (i.e., by performing laser processing) from under the second surface 12 of the pyroelectric substrate 1. That is to say, scanning the pyroelectric substrate 1 with the laser beam L1 along the sides of the second electrode 3 while irradiating, with the laser beam L1, the pyroelectric substrate 1 from the second surface 12 side thereof, on which the second electrode 3 is provided, allows the through hole 19 to be formed. Note that when the laser processing is performed, scanning does not have to be performed only once but may also be performed multiple times.

As shown in FIGS. 1 and 2, the infrared detection element 10 further includes a first electrical conductor 5 and a second electrical conductor 6. Note that in FIGS. 3 and 4, illustration of the first electrical conductor 5 and the second electrical conductor 6 is omitted.

As shown in FIG. 1, the first electrical conductor 5 is provided on a part, corresponding to the supporting portion 16, of the first surface 11 of the pyroelectric substrate 1. The first electrical conductor 5 is connected to the first electrodes 2. The first electrical conductor 5 is made of the same material as the first electrodes 2 to be as thick as the first electrodes 2. The first electrical conductor 5 may be formed simultaneously with the first electrodes 2.

As shown in FIG. 1, the infrared detection element 10 according to this embodiment includes two electrical conductors 5. In the following description, if the two electrical conductors 5 need to be distinguished from each other, the two electrical conductors 5 will be hereinafter referred to as "electrical conductors 51, 52."

The first electrical conductor 51 connects the first electrode 2 of the detection unit 101 to the first electrode 2 of the detection unit 104. The first electrical conductor 52 connects the first electrode 2 of the detection unit 102 to the first electrode 2 of the detection unit 103.

As shown in FIG. 2, the second electrical conductor 6 is provided on a part, corresponding to the supporting portion 16, of the second surface 12 of the pyroelectric substrate 1. The second electrical conductor 6 is connected to the second electrodes 3. The second electrical conductor 6 is made of the same material as the second electrodes 3 to be as thick as the second electrodes 3. The second electrical conductor 6 may be formed simultaneously with the second electrodes 3.

As shown in FIG. 2, the infrared detection element 10 according to this embodiment includes two electrical conductors 6. In the following description, if the two electrical conductors 6 need to be distinguished from each other, the two electrical conductors 6 will be hereinafter referred to as "electrical conductors 61, 62."

The second electrical conductor 61 connects the second electrode 3 of the detection unit 101 to the second electrode 3 of the detection unit 104. The second electrical conductor 62 connects the second electrode 3 of the detection unit 102 to the second electrode 3 of the detection unit 103.

### (1.2.2) Method for Manufacturing Infrared Detection Element

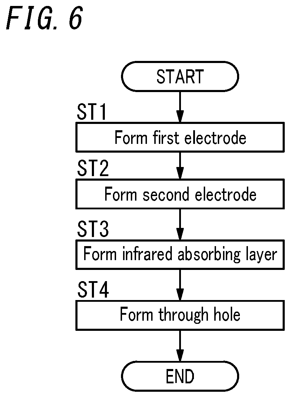

A method for manufacturing the infrared detection element 10 will be described with reference to FIGS. 6 and 7.

As shown in the flowchart in FIG. 6, the method for manufacturing the infrared detection element 10 includes a first electrode forming process step ST1, a second electrode forming process step ST2, an infrared absorbing layer forming process step ST3, and a through hole forming process step ST4.

The first electrode forming process step ST1 includes forming the first electrode 2 on the first surface 11 of the pyroelectric substrate 1 having the first surface 11 and the second surface 12 in the thickness direction D1. In the first electrode forming process step ST1, the first electrode 2 is formed by using, for example, an evaporation method or a sputtering method. Note that the first electrical conductor 5 may also be formed simultaneously with the first electrode 2 in the first electrode forming process step ST1.

The second electrode forming process step ST2 includes forming the second electrode 3 on the second surface 12 of the pyroelectric substrate 1. The second electrode 3 is formed to overlap with the first electrode 2 in the thickness direction D1 defined with respect to the pyroelectric substrate 1. In the second electrode forming process step ST2, the second electrode 3 is formed by using, for example, an evaporation method or a sputtering method. Note that the second electrical conductor 6 may also be formed simultaneously with the second electrode 3 in the second electrode forming process step ST2.

The infrared absorbing layer forming process step ST3 includes forming the infrared absorbing layer 4 on the first electrode 2. In the infrared absorbing layer forming process step ST3, a paste prepared by dispersing an electrically conductive fine powder in a resin and adding an organic solvent thereto is printed by, for example, screen printing or gravure printing. Then, the paste thus printed is cured by baking to form the infrared absorbing layer 4.

The through hole forming process step ST4 is performed after the infrared absorbing layer forming process step ST3 has been performed. The through hole forming process step ST4 includes forming the through hole 19 through the pyroelectric substrate 1. The through hole 19 is formed to surround the specific portion 13 that is a part, sandwiched between the first electrode 2 and the second electrode 3, of the pyroelectric substrate 1. The through hole 19 has a tapered structure in which its width adjacent to the first surface 11 is narrower than its width adjacent to the second surface 12.

In the through hole forming process step ST4, the through hole 19 is formed by irradiating the pyroelectric substrate 1 with a laser beam L1, for example. That is to say, the through hole forming process step ST4 includes a laser processing step. In the laser processing step, irradiating, with the laser beam L1 (refer to FIG. 7), the pyroelectric substrate 1 from the second surface 12 side thereof allows for forming the through hole 19 having such a tapered structure in which its width adjacent to the first surface 11 is narrower than its width adjacent to the second surface 12. In FIG. 7, each region, in which the through hole 19 is to be formed, of the pyroelectric substrate 1 is indicated by the chain-dotted lines for the sake of convenience.

Note that the flowchart shown in FIG. 6 is only an example and should not be construed as limiting. Optionally, as needed, the processing steps may be performed in a different order from the illustrated one or an additional processing step may be performed. Still optionally, a plurality of infrared detection elements 10 may also be manufactured simultaneously by performing a dicing process after a plurality of infrared detection elements 10 have been formed on a wafer which forms the basis of the pyroelectric substrate 1.

### (1.2.3) Advantages of Infrared Detection Element

In the infrared detection element 10 according to this embodiment, the pyroelectric substrate 1 has the through hole 19 having a tapered structure in which its width W1 adjacent to the first surface 11 is narrower than its width W2 adjacent to the second surface 12. This may contribute to increasing the sensitivity of the infrared detection element 10. Next, this point will be described in comparison with comparative examples, namely, an infrared detection element according to a first comparative example and an infrared detection element according to a second comparative example.

Each of the infrared detection element according to the first comparative example and the infrared detection element according to the second comparative example basically has the same configuration as the infrared detection element 10 according to this embodiment. However, each of the infrared detection elements according to the first comparative example and the infrared detection element according to the second comparative example has a pyroelectric substrate with a through hole having a tapered structure in which its width adjacent to the first surface is wider than its width adjacent to the second surface. This is a difference from the infrared detection element 10 according to this embodiment. The through hole having such a tapered structure in which its width adjacent to the first surface is wider than its width adjacent to the second surface may be formed by performing processing from the first surface side of the pyroelectric substrate. In addition, the infrared detection element according to the first comparative example and the infrared detection element according to the second comparative example are also different from each other mainly in the method for forming a through hole.

In the infrared detection element according to the first comparative example, the through hole is formed by performing sandblasting from the first surface side by blast processing.

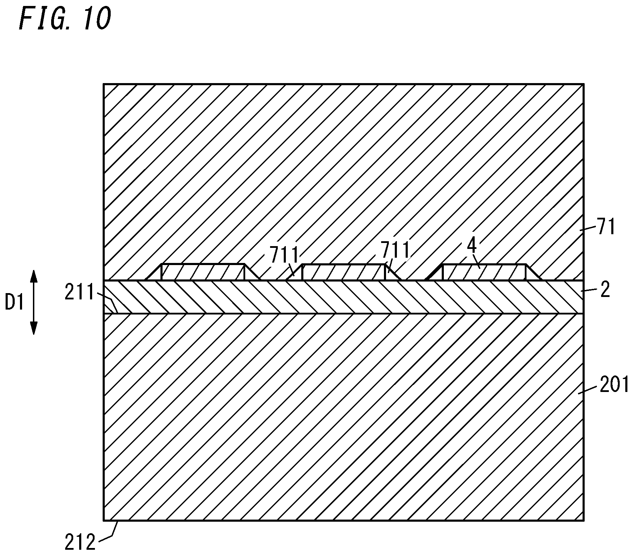

A method for manufacturing such an infrared detection element according to the first comparative example will be briefly described with reference to FIG. 10.

In the method for manufacturing the infrared detection element according to the first comparative example, first, a first electrode 2 and an infrared absorbing layer 4 are formed on a first surface 211 of a wafer 201 forming the basis of a pyroelectric substrate 1 which has the first surface 211 and a second surface 212 in the thickness direction D1. Note that in FIG. 10, only one first electrode 2 is illustrated as covering the entire first surface 211 of the wafer 201 for the sake of convenience. Actually, however, a plurality of first electrodes 2 corresponding one to one to a plurality of detection units 100 are provided on the first surface 211 of the wafer 201, and adjacent ones of the first electrodes 2 are spaced apart from each other.

Then, in the method for manufacturing the infrared detection element according to the first comparative example, a photoresist film 71, serving as a mask for blast processing, is applied onto the first surface 211 of the wafer 201. Thereafter, in the method for manufacturing the infrared detection element according to the first comparative example, a hole conforming in shape to the through hole is provided through the photoresist film 71 by an exposure process and a development process. After that, in the method for manufacturing the infrared detection element according to the first comparative example, an abrasive such as sand (i.e., performing sandblasting) is projected, via the hole provided through the photoresist film 71, from the first surface 211 side of the wafer 201, and as a result the through hole through the wafer 201 is formed.

The through hole thus formed has such a tapered structure in which its width adjacent to the first surface 211 (the surface to which the abrasive is projected) is wider than its width adjacent to the second surface 212.

In the infrared detection element according to the first comparative example to be formed by such a manufacturing method, the photoresist film 71 needs to be applied onto the first electrode 2 and the infrared absorbing layer 4 as described above. However, the method for manufacturing the infrared detection element according to the first comparative example may sometimes fail to apply the photoresist film 71 in close contact with the infrared absorbing layer 4 on the first surface 211 as shown in FIG. 10, thus possibly leaving a gap 711 between the photoresist film 71 and the first surface 211 of the wafer 201. If the abrasive is projected from the first surface 211 side in this state, then the abrasive may enter the gap 711 and come into contact with an unintended region, other than the region through which the through hole is to be formed, of the wafer 201. This may cause a failure to form a through hole having the originally designed shape. In addition, the abrasive that has entered the gap 711 possibly causes a defect such as deformation of the infrared absorbing layer 4. This may cause a decrease in the sensitivity of the infrared detection element according to the first comparative example.

In contrast, the infrared detection element 10 according to this embodiment uses neither the photoresist film 71 nor the abrasive that are used in the method for manufacturing the infrared detection element according to the first comparative example, thus reducing the chances of causing a defect such as deformation of the infrared absorbing layer 4. Consequently, the infrared detection element 10 according to this embodiment may have higher sensitivity than the infrared detection element according to the first comparative example.

Next, in the method for manufacturing the infrared detection element according to the second comparative example, irradiating the pyroelectric substrate 1 with a laser beam from the first surface 11 side of the pyroelectric substrate 1 causes a through hole to be formed. The through hole thus formed has such a tapered structure in which its width adjacent to the first surface 11 (the surface irradiated with the laser beam) is wider than its width adjacent to the second surface 12.

In the infrared detection element according to the second comparative example, the heat generated by the energy of the laser beam radiated from the first surface 11 side may possibly cause some type of alteration (e.g., oxidation or peeling) to the second electrode 3 on the second surface 12. The alteration of the second electrode 3 may cause a decrease in the sensitivity of the infrared detection element.

In contrast, in the infrared detection element 10 according to this embodiment, the through hole 19 is formed by irradiating, with the laser beam L1, the pyroelectric substrate 1 from the second surface 12 side thereof as shown in FIG. 7. In this case, the heat generated by the energy of the laser beam L1 radiated from the second surface 12 side is absorbed mainly into the infrared absorbing layer 4. This reduces the chances of causing alteration to the first electrode 2 and the second electrode 3. Consequently, the infrared detection element 10 according to this embodiment may have higher sensitivity than the infrared detection element according to the second comparative example.

In particular, the side surfaces 23 of the first electrode 2 are covered by the infrared absorbing layer 4, and thus, the heat generated by the energy of the laser beam L1 is more easily absorbed into the infrared absorbing layer 4 rather than into the first electrode 2. This further reduces the chances of causing alteration to the first electrode 2, which allows for contributing to further increasing the sensitivity of the infrared detection element 10.

As can be seen from the foregoing description, the infrared detection element 10 according to this embodiment may advantageously contribute to increasing the sensitivity thereof compared with the infrared detection element according to the first comparative example and the infrared detection element according to the second comparative example.

### (1.2.4) Infrared Sensor

An infrared sensor 20 according to this embodiment will be described with reference to FIG. 5.

As shown in FIG. 5, the infrared sensor 20 includes the infrared detection element 10, a mounting board 8 on which the infrared detection element 10 is mounted, and a package 9 for housing the infrared detection element 10 and the mounting board 8. Note that in FIG. 5, illustration of the first electrical conductor 5 and other members of the infrared detection element 10 is omitted for the sake of convenience.

As shown in FIG. 5, the infrared sensor 20 further includes a signal processing unit 200. The signal processing unit 200 is implemented as, for example, a single-chip IC (integrated circuit). The signal processing unit 200 performs signal processing on an output signal supplied as an output current from the infrared detection element 10. The signal processing unit 200 outputs a human detection signal, for example, to an external device in response to the output signal of the infrared detection element 10. The signal processing unit 200 outputs the human detection signal as an output signal when the signal level of the output signal of the infrared detection element 10 exceeds a threshold value, for example.

The mounting board 8 is a MID (Molded Interconnect Device). In the infrared sensor 20, the infrared detection element 10 and the signal processing unit 200 are mounted on the mounting board 8.

The package 9 is a so-called "can package." The package 9 includes a base 91, a cap 92, a window member 93, and a plurality of (three) lead terminals 94.

The base 91 has electrical conductivity. The base 91 is made of, for example, a metal. The base 91 has a disk shape. The mounting board 8 is supported on the upper surface of the base 91.

The cap 92 has electrical conductivity. The cap 92 is made of, for example, a metal. The cap 92 has a bottomed cylindrical shape. The cap 92 is fixed to the base 91 to cover the mounting board 8, the signal processing unit 200, and the infrared detection element 10. Through an upper wall 921 of the cap 92, provided is a window hole having a shape conforming to the shape of the infrared detection element 10.

The window member 93 is made of an infrared transmitting material which transmits an infrared ray. The window member 93 has electrical conductivity. The window member 93 includes, for example, a silicon substrate and an infrared optical filter stacked on the silicon substrate. The infrared optical filter is configured as an optical multilayer film which transmits an infrared ray having a wavelength falling within the wavelength range of a target to be detected by the infrared sensor 20.

The window member 93 is arranged to close the window hole of the upper wall 921 of the cap 92. The window member 93 is disposed over the infrared detection element 10.

The three lead terminals 94 are held by the base 91. Each of the three lead terminals 94 has a pin shape. Each of the three lead terminals 94 penetrates through the base 91 in a thickness direction defined with respect to the base 91. The three lead terminals 94 serve as, for example, a power supply lead terminal, a signal output lead terminal, and a ground lead terminal.

### (2) Variations

The embodiment described above is only an exemplary one of various embodiments of the present disclosure and should not be construed as limiting. Rather, the exemplary embodiment may be readily modified in various manners depending on a design choice or any other factor without departing from the scope of the present disclosure. Next, variations of the exemplary embodiment will be enumerated one after another. Note that the embodiment described above and any of the variations to be described below may be adopted in combination as appropriate.

### (2.1) First Variation

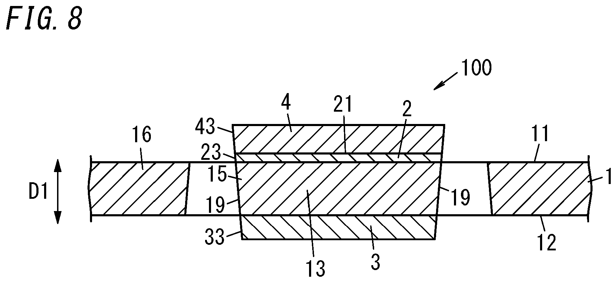

An infrared detection element 10 according to a first variation will be described with reference to FIG. 8.

In the infrared detection element 10 according to this variation, a first electrode 2 and a second electrode 3 are provided to entirely cover a predetermined portion 15 surrounded by a through hole 19 of a pyroelectric substrate 1 as shown in FIG. 8. That is to say, in this variation, the predetermined portion 15 is the same as the specific portion 13 (i.e., a part, sandwiched between the first electrode 2 and the second electrode 3, of the pyroelectric substrate 1). Also, as shown in FIG. 8, the side surface 23 of the first electrode 2, the inner surface of the through hole 19 of the pyroelectric substrate 1, and the side surface 33 of the second electrode 3 are seamlessly connected to each other. As used herein, the expression "two surfaces are seamlessly connected to each other" means that the two surfaces are connected to each other substantially without a level difference. Furthermore, in this embodiment, an infrared absorbing layer 4 is provided only on the (entire) upper surface 21 of the first electrode 2. The side surfaces 43 of the infrared absorbing layer 4 are seamlessly connected to the side surfaces 23 of the first electrode 2.

A through hole 19 such as the one according to this variation may be formed by performing laser processing. First, a first electrically conductive layer which forms the basis of the first electrode 2 and an electrically conductive resin layer which forms the basis of the infrared absorbing layer 4 are provided on the first surface 11 of the pyroelectric substrate 1, for example. Meanwhile, a second electrically conductive layer which forms the basis of the second electrode 3 is provided on the second surface 12 of the pyroelectric substrate 1. Then, a laser beam is radiated from the second surface 12 side of the pyroelectric substrate 1 to simultaneously remove, by the laser beam at a time, an edge portion of the first electrically conductive layer, an edge portion of the second electrically conductive layer, a part corresponding to the through hole 19, of the pyroelectric substrate 1, and an edge portion of the electrically conductive resin layer. In this manner, such a structure (refer to FIG. 8), in which the side surface 23 of the first electrode 2, the inner surface of the through hole 19 of the pyroelectric substrate 1, the side surface 33 of the second electrode 3, and the side surface 43 of the infrared absorbing layer 4 are seamlessly connected to each other, is formed.

The infrared detection element 10 according to this variation, as well as the infrared detection element 10 according to the embodiment, may also contribute to increasing the sensitivity.

In addition, in the infrared detection element 10 according to this variation, the profile of the infrared absorbing layer 4 is determined by laser processing, which allows for reducing a variation in the dimensions of the infrared absorbing layer 4 from one element to another. This may contribute to reducing a variation in sensitivity among the elements.

### (2.2) Second Variation

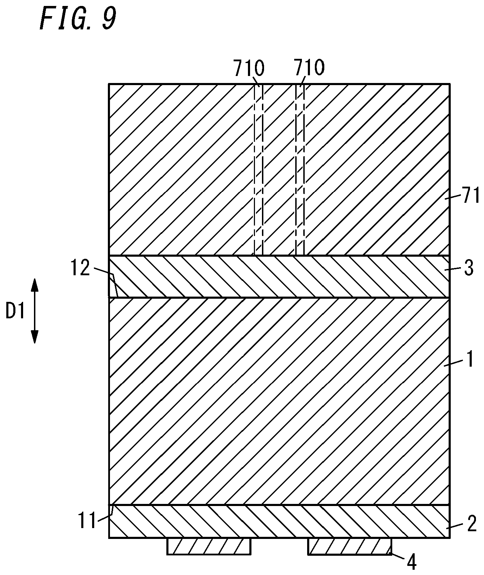

An infrared detection element 10 according to a second variation will be described with reference to FIG. 9. The structure of the infrared detection element 10 according to this variation is the same as the structure of the infrared detection element 10 according to the embodiment (refer to FIGS. 1-4). The infrared detection element 10 according to this variation is different from the infrared detection element 10 according to the embodiment in a method for forming a through hole 19.

In the infrared detection element 10 according to this variation, the through hole 19 is formed by performing blast processing. That is to say, in the method for manufacturing the infrared detection element 10 according to this variation, the through hole forming process step ST4 includes a blast processing step.

In the through hole forming process step ST4 according to this variation, a photoresist film 71, serving as a mask for blast processing, is applied onto the second surface 12 of the pyroelectric substrate 1 as shown in FIG. 9. In the example shown in FIG. 9, the photoresist film 71 is applied onto the second electrode 3 that has been formed on the second surface 12 of the pyroelectric substrate 1. Note that in FIG. 9, only one first electrode 2 and only one second electrode 3 are illustrated as respectively covering the entire first surface 11 and the entire second surface 12 of the pyroelectric substrate 1 for the sake of convenience. Actually, however, a plurality of first electrodes 2 and a plurality of second electrodes 3 that correspond one to one to the plurality of detection units 100 are provided on the pyroelectric substrate 1, and adjacent ones of the first electrodes 2 are spaced apart from each other and adjacent ones of the second electrodes 3 are spaced apart from each other.

In addition, the through hole forming process step ST4 according to this variation includes opening a hole 710 conforming in shape to the through hole 19 through the photoresist film 71 by an exposure process and a development process.

The through hole forming process step ST4 according to this variation includes projecting , via the photoresist film 71, an abrasive such as sand (i.e., performing sandblasting) from the second surface 12 side of the pyroelectric substrate 1, thereby forming a through hole 19 through the pyroelectric substrate 1.

The through hole 19 thus formed has a tapered structure (refer to FIGS. 3 and 4) in which its width adjacent to the first surface 11 is narrower than its width adjacent to the second surface 12 (the surface to which the abrasive is projected).

In the method for manufacturing the infrared detection element 10 according to this variation, the photoresist film 71 is applied onto the second surface 12 on which no infrared absorbing layer 4 is provided. Thus, the method for manufacturing the infrared detection element 10 according to this variation reduces the chances of leaving a gap (refer to the gaps 711 shown in FIG. 10) between the photoresist film 71 and the pyroelectric substrate 1 compared with the method for manufacturing the infrared detection element according to the first comparative example. Consequently, the infrared detection element 10 according to this variation reduces the chances of causing a defect such as deformation of the infrared absorbing layer 4 compared with the infrared detection element according to the first comparative example. Furthermore, the infrared detection element 10 according to this variation advantageously makes it easier to form a through hole 19 having a desired shape.

### (2.3) Other Variations

In one variation, the side surfaces 23 of the first electrode 2 may be covered by the infrared absorbing layer 4 and the side surface 43 of the infrared absorbing layer 4 and the inner surface of a through hole 19 of the pyroelectric substrate 1 may be seamlessly connected to each other.

In another variation, the side surfaces 23 of the first electrode 2 does not have to be covered by the infrared absorbing layer 4 and a through hole 19 may be formed to be spaced apart from the side surfaces 23 of the first electrode 2.

In still another variation, the first electrode 2 and the second electrode 3 may be different from each other in dimensions or shape. In that case, the specific portion 13 is defined as a region, overlapping with both the first electrode 2 and the second electrode 3, of the pyroelectric substrate 1.

In yet another variation, the specific portion 13 does not have to have a rectangular shape when viewed in plan. Alternatively, the specific portion 13 may also have a circular shape, a semicircular shape, an elliptical shape, a semi-elliptical shape, or a polygonal shape other than the rectangular shape.

### (3) Aspects

As can be seen from the foregoing description of an exemplary embodiment and its variations, the foregoing description provides specific implementations for the following aspects of the present disclosure.

An infrared detection element (10) according to a first aspect includes a pyroelectric substrate (1), a first electrode (2), a second electrode (3), and an infrared absorbing layer (4). The pyroelectric substrate (1) has a first surface (11) and a second surface (12) in a thickness direction (D1). The first electrode (2) is provided on the first surface (11) of the pyroelectric substrate (1). The second electrode (3) is provided on the second surface (12) of the pyroelectric substrate (1) such that the second electrode (3) overlaps with the first electrode (2) in the thickness direction (D1). The infrared absorbing layer (4) is provided on the first electrode (2). The pyroelectric substrate (1) has a through hole (19) penetrating through the pyroelectric substrate (1) in the thickness direction (D1). The through hole (19) is provided around a specific portion (13), sandwiched between the first electrode (2) and the second electrode (3), of the pyroelectric substrate (1). The through hole (19) has a tapered structure in which a width of the through hole (19) as measured adjacent to the first surface (11) is narrower than a width of the through hole (19) as measured adjacent to the second surface (12).

This aspect may contribute to increasing the sensitivity of the infrared detection element (10).

In an infrared detection element (10) according to a second aspect, which may be implemented in conjunction with the first aspect, the specific portion (13) has a rectangular shape. The through hole (19) is arranged around the specific portion (13) to extend along three sides of the specific portion (13).

This aspect may contribute to further increasing the sensitivity of the infrared detection element (10).

In an infrared detection element (10) according to a third aspect, which may be implemented in conjunction with the first or second aspect, the first electrode (2) has a thickness equal to or greater than 0.05 µm and equal to or less than 5 µm. The second electrode (3) has a thickness equal to or greater than 0.05 µm and equal to or less than 5 µm.

This aspect may contribute to increasing the sensitivity of the infrared detection element (10).

In an infrared detection element (10) according to a fourth aspect, which may be implemented in conjunction with any one of the first to third aspects, the infrared absorbing layer (4) is a layer made of a resin into which an electrically conductive fine powder is dispersed. The infrared absorbing layer (4) has a thickness equal to or greater than 0.1 µm and equal to or less than 5 µm.

This aspect may contribute to increasing the sensitivity of the infrared detection element (10).

In an infrared detection element (10) according to a fifth aspect, which may be implemented in conjunction with any one of the first to fourth aspects, the infrared absorbing layer (4) is provided to cover a side surface (23) of the first electrode (2).

This aspect may contribute to further increasing the sensitivity of the infrared detection element (10).

In an infrared detection element (10) according to a sixth aspect, which may be implemented in conjunction with any one of the first to fifth aspects, the through hole (19) is provided to be spaced apart from the specific portion (13).

This aspect may contribute to increasing the sensitivity of the infrared detection element (10).

In an infrared detection element (10) according to a seventh aspect, which may be implemented in conjunction with any one of the first to fifth aspects, a side surface (23) of the first electrode (2), an inner surface of the through hole (19) of the pyroelectric substrate (1), and a side surface (33) of the second electrode (3) are seamlessly connected to each other.

This aspect may contribute to reducing a variation in sensitivity among the elements.

An infrared sensor (20) according to an eighth aspect includes the infrared detection element (10) according to any one of the first to seventh aspects, a mounting board (8), and a package (9). The infrared detection element (10) is mounted on the mounting board (8). The package (9) houses the infrared detection element (10) and the mounting board (8).

This aspect may contribute to increasing the sensitivity of the infrared detection element (10).

A method for manufacturing an infrared detection element (10) according to a ninth aspect includes a first electrode forming process step (ST1), a second electrode forming process step (ST2), an infrared absorbing layer forming process step (ST3), and a through hole forming process step (ST4). The first electrode forming process step (ST1) includes forming a first electrode (2) on a first surface (11) of a pyroelectric substrate (1). The pyroelectric substrate (1) has the first surface (11) and a second surface (12) in a thickness direction (D1). The second electrode forming process step (ST2) includes forming a second electrode (3) on the second surface (12) of the pyroelectric substrate (1) such that the second electrode (3) overlaps with the first electrode (2) in the thickness direction (D1). The infrared absorbing layer forming process step (ST3) includes forming an infrared absorbing layer (4) on the first electrode (2). The through hole forming process step (ST4) is performed after the infrared absorbing layer forming process step (ST3) has been performed. The through hole forming process step (ST4) includes forming a through hole (19) through the pyroelectric substrate (1) such that the through hole (19) surrounds a specific portion (13) sandwiched between the first electrode (2) and the second electrode (3). The through hole (19) has a tapered structure in which a width of the through hole (19) as measured adjacent to the first surface (11) is narrower than a width of the through hole (19) as measured adjacent to the second surface (12).

This aspect may contribute to increasing the sensitivity of the infrared detection element (10).

In a method for manufacturing an infrared detection element (10) according to a tenth aspect, which may be implemented in conjunction with the ninth aspect, the through hole forming process step (ST4) includes a laser processing step. The laser processing step includes forming the through hole (19) by irradiating the pyroelectric substrate (1) with a laser beam (L1) from a side of the second surface (12) of the pyroelectric substrate (1).

### Reference Signs List

- 10: Infrared Detection Element
- 20: Infrared Sensor
- 1: Pyroelectric Substrate
- 11: First Surface
- 12: Second Surface
- 13: Specific Portion
- 19: Through Hole
- 2: First Electrode
- 23: Side Surface
- 3: Second Electrode
- 33: Side Surface
- 4: Infrared Absorbing Layer
- 8: Mounting Board
- 9: Package
- D1: Thickness Direction
- L1: Laser Beam
- ST1: First Electrode Forming Process Step
- ST2: Second Electrode Forming Process Step
- ST3: Infrared Absorbing Layer Forming Process Step
- ST4: Through Hole Forming Process Step

## Claims

1. An infrared detection element comprising:
a pyroelectric substrate having a first surface and a second surface in a thickness direction;
a first electrode provided on the first surface of the pyroelectric substrate;
a second electrode provided on the second surface of the pyroelectric substrate such that the second electrode overlaps with the first electrode in the thickness direction; and
an infrared absorbing layer provided on the first electrode,
the pyroelectric substrate having a through hole penetrating through the pyroelectric substrate in the thickness direction,
the through hole being provided around a specific portion, sandwiched between the first electrode and the second electrode, of the pyroelectric substrate, and
the through hole having a tapered structure in which a width of the through hole as measured adjacent to the first surface is narrower than a width of the through hole as measured adjacent to the second surface.

2. The infrared detection element of claim 1, wherein
the specific portion has a rectangular shape, and
the through hole is arranged around the specific portion to extend along three sides of the specific portion.

3. The infrared detection element of claim 1 or 2, wherein
the first electrode has a thickness equal to or greater than 0.05 µm and equal to or less than 5 µm, and
the second electrode has a thickness equal to or greater than 0.05 µm and equal to or less than 5 µm.

4. The infrared detection element of any one of claims 1 to 3, wherein
the infrared absorbing layer is a layer made of a resin into which an electrically conductive fine powder is dispersed, and
the infrared absorbing layer has a thickness equal to or greater than 0.1 µm and equal to or less than 5 µm.

5. The infrared detection element of any one of claims 1 to 4, wherein
the infrared absorbing layer is provided to cover a side surface of the first electrode.

6. The infrared detection element of any one of claims 1 to 5, wherein
the through hole is provided to be spaced apart from the specific portion.

7. The infrared detection element of any one of claims 1 to 5, wherein
a side surface of the first electrode, an inner surface of the through hole of the pyroelectric substrate, and a side surface of the second electrode are seamlessly connected to each other.

8. An infrared sensor comprising:
the infrared detection element of any one of claims 1 to 7;
a mounting board on which the infrared detection element is mounted; and
a package housing the infrared detection element and the mounting board.

9. A method for manufacturing an infrared detection element, the method comprising:
a first electrode forming process step including forming a first electrode on a first surface of a pyroelectric substrate, the pyroelectric substrate having the first surface and a second surface in a thickness direction;
a second electrode forming process step including forming a second electrode on the second surface of the pyroelectric substrate such that the second electrode overlaps with the first electrode in the thickness direction;
an infrared absorbing layer forming process step including forming an infrared absorbing layer on the first electrode; and
a through hole forming process step including forming a through hole through the pyroelectric substrate such that the through hole surrounds a specific portion sandwiched between the first electrode and the second electrode, the through hole having a tapered structure in which a width of the through hole as measured adjacent to the first surface is narrower than a width of the through hole as measured adjacent to the second surface, the through hole forming process step being performed after the infrared absorbing layer forming process step has been performed.

10. The method of claim 9, wherein
the through hole forming process step includes a laser processing step, the laser processing step including forming the through hole by irradiating the pyroelectric substrate with a laser beam from a side of the second surface of the pyroelectric substrate.
